(19) **Europäisches Patentamt / European Patent Office / Office européen des brevets**

(11) **EP 2 685 291 B1**

(12) **FASCICULE DE BREVET EUROPEEN**

(45) Date de publication et mention de la délivrance du brevet:
**09.03.2022 Bulletin 2022/10**

(21) Numéro de dépôt: **13305753.9**

(22) Date de dépôt: **05.06.2013**

(51) Classification Internationale des Brevets (IPC):
**G01V 99/00** (2009.01)

(52) Classification Coopérative des Brevets (CPC):
**G01V 99/005**

(54) **Procédé d'exploitation d'un réservoir géologique a partir d'un modèle de reservoir calé par le calcul d'une loi analytique de distribution conditionnelle de paramètres incertains du modèle**

Verfahren zur Ausbeutung eines geologischen Reservoirs auf der Grundlage eines Reservoirmodells, das auf einer Berechnung eines analytischen Verteilungsgesetzes beruht, das durch unsichere Parameter des Modells bedingt ist

Method for exploiting a geological reservoir from a reservoir model conditioned by calculating an analytic law of the conditional distribution of uncertain parameters of the model

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **13.07.2012 FR 1202005**

(43) Date de publication de la demande:
**15.01.2014 Bulletin 2014/03**

(73) Titulaire: **IFP Energies nouvelles**
**92500 Rueil-Malmaison (FR)**

(72) Inventeurs:
- **Da Veiga, Sebastien**
  **75005 PARIS (FR)**
- **Gervais-Couplet, Veronique**
  **92500 RUEIL-MALMAISON (FR)**
- **Feraille, Mathieu**
  **78800 HOUILLES (FR)**

(74) Mandataire: **IFP Energies nouvelles**
**Département Propriété Industrielle**
**Rond Point de l'échangeur de Solaize**
**BP3**
**69360 Solaize (FR)**

(56) Documents cités:
**WO-A2-2008/028122**

- BUSBY D ET AL: "Adaptive design of experiments for calibration of complex simulators â An application to uncertainty quantification of a mature oil field", JOURNAL OF PHYSICS: CONFERENCE SERIES, INSTITUTE OF PHYSICS PUBLISHING, BRISTOL, GB, vol. 135, no. 1, 1 novembre 2008 (2008-11-01), page 12026, XP020147944, ISSN: 1742-6596
- A. G. Madatov: "An effective field scale reservoir model for history matching and reservoir prediction. Part 2. Parametrical upscaling and calibration", , 1 janvier 2010 (2010-01-01), pages 495-540, XP055056919, Extrait de l'Internet: URL:http://vestnik.mstu.edu.ru/v13_3_n40/a rticles/02_madatov.pdf [extrait le 2013-03-18]
- Mathieu Feraille ET AL: "UNCERTAINTY QUANTIFICATION FOR MATURE FIELD COMBINING THE BAYESIAN INVERSION FORMALISM AND EXPERIMENTAL DESIGN APPROACH", 9th European Conference on the Mathematics of Oil Recovery - Cannes, 1 September 2004 (2004-09-01), XP055444632, Retrieved from the Internet: URL:https://extras.springer.com/2003/978-3 -540-43868-7/Data/A030.pdf [retrieved on 2018-01-25]
- M. FERAILLE ET AL: "Prediction under Uncertainty on a Mature Field", OIL & GAS SCIENCE & TECHNOLOGY: REVUE DE L'INSTITUT FRANCAIS DU PETROLE, vol. 67, no. 2, 1 March 2012 (2012-03-01), pages 193-206, XP055444642, Fr ISSN: 1294-4475, DOI: 10.2516/ogst/2011172

## Description

La présente invention concerne le domaine technique de l'industrie pétrolière, et plus particulièrement l'exploitation de réservoirs souterrains, tels que des réservoirs pétroliers ou des sites de stockage de gaz.

L'optimisation et l'exploitation d'un gisement pétrolier reposent sur une description aussi précise que possible de la structure, des propriétés pétrophysiques, des propriétés des fluides, etc., du gisement étudié. Pour ce faire, les spécialistes utilisent un outil qui permet de rendre compte de ces aspects de façon approchée : le modèle de réservoir. Un tel modèle constitue une maquette du sous-sol, représentative à la fois de sa structure et de son comportement. Généralement, ce type de maquette est représenté sur un ordinateur, et l'on parle alors de modèle numérique. Un modèle de réservoir comporte un maillage ou grille, généralement tridimensionnelle, associée à une ou plusieurs cartes de propriétés pétrophysiques (porosité, perméabilité, saturation...). L'association consiste à attribuer des valeurs de ces propriétés pétrophysiques à chacune des mailles de la grille.

Ces modèles bien connus et largement utilisés dans l'industrie pétrolière, permettent de déterminer de nombreux paramètres techniques relatifs à l'étude ou l'exploitation d'un réservoir, d'hydrocarbures par exemple. En effet, puisque le modèle de réservoir est représentatif de la structure du réservoir et de son comportement, un spécialiste peut l'utiliser par exemple pour déterminer les zones qui ont le plus de chances de contenir des hydrocarbures, les zones dans lesquelles il peut être intéressant/nécessaire de forer un puits d'injection ou de production pour améliorer la récupération des hydrocarbures, le type d'outils à utiliser, les propriétés des fluides utilisés et récupérés.... Ces interprétations de modèles de réservoir en termes de « paramètres techniques d'exploitation » sont bien connues des spécialistes. De la même façon, la modélisation des sites de stockages de $CO_2$ permet de surveiller ces sites, de détecter des comportements inattendus et de prédire le déplacement du $CO_2$ injecté.

Afin de réaliser ces différentes interprétations, les spécialistes ont besoin de connaître le comportement dynamique de leur modèle de réservoir. Ceci est réalisé en simulant les écoulements de fluides au sein d'un réservoir au moyen d'un logiciel appelé simulateur d'écoulement. C'est ce qui est appelé une simulation de réservoir. Une ou plusieurs simulations de réservoir peuvent être nécessaires. Le logiciel PumaFlow ® (IFP Energies nouvelles, France) est un exemple de simulateur d'écoulement utilisé dans le domaine de l'exploitation des réservoirs souterrains.

Ces interprétations sont réalisées à l'aide d'un modèle de réservoir que l'on souhaite le plus représentatif possible, c'est-à-dire cohérent avec toutes les données disponibles. Ces données comprennent en général :

- des mesures en certains points de la formation géologique de la propriété modélisée, par exemple dans des puits. Ces données sont dites statiques car elles sont invariables dans le temps (à l'échelle des temps de la production du réservoir) et sont directement liées à la propriété d'intérêt, et

- des "données d'historique", comprenant des données de production, par exemple les débits de fluide mesurés aux puits ou les concentrations de traceurs et des données issues de campagnes d'acquisition sismique répétées à des temps successifs, dites de sismique 4D. Ces données sont dites dynamiques car elles évoluent en cours d'exploitation et sont indirectement liées aux propriétés attribuées aux mailles du modèle de réservoir.

Le nombre de données statiques disponibles étant très faible par rapport au nombre de mailles du modèle de réservoir, des extrapolations sont nécessaires. Par exemple des méthodes probabilistes peuvent être utilisées pour remplir le modèle en propriétés pétrophysiques. Dans ce cas les données statiques disponibles sont utilisées pour définir des fonctions aléatoires pour chaque propriété pétrophysique comme la porosité ou la perméabilité. Une représentation de la répartition spatiale d'une propriété pétrophysique est une réalisation d'une fonction aléatoire. De façon générale, une réalisation est générée à partir d'une part d'une moyenne, d'une variance et d'une fonction de covariance qui caractérise la variabilité spatiale de la propriété étudiée et d'autre part d'un germe ou d'une série de nombres aléatoires. De nombreuses techniques de simulation, dites simulations géostatistiques, existent comme la méthode de simulation séquentielle Gaussienne, la méthode de Cholesky ou encore la méthode de transformée de Fourier rapide avec moyenne mobile FFT-MA. Ces techniques sont décrites notamment dans les documents suivants :

- Goovaerts,P., 1997, Geostatistics for natural resources évaluation, Oxford Press, New York, 483 p.

- Le Ravalec, M., Nœtinger B., and Hu L.-Y., 2000, The FFT moving average (FFT-MA) generator: an efficient numerical method for generating and conditioning Gaussian simulations, Mathematical Geology, 32(6), 701-723.

La construction d'un modèle de réservoir représentatif se fait par étapes. Tout d'abord, on construit un modèle de réservoir sur la base des données statiques. Puis ce modèle est mis à jour afin de reproduire au mieux les données d'historique via la simulation d'écoulement tout en conservant la cohérence avec les données statiques.

Les techniques d'intégration des données dynamiques (données de production et/ou sismique 4D) dans un modèle de réservoir sont bien connues des spécialistes : ce sont des techniques dites de "calage d'historique" ("history-matching" en anglais).

Le calage d'historique consiste à modifier les paramètres d'un modèle de réservoir, tels que les perméabilités, les porosités ou les skins de puits (représentant les endommagements autour du puits), les connections de failles..., pour minimiser les écarts entre les données d'historique mesurées et les réponses correspondantes simulées à partir du modèle de réservoir. Les paramètres peuvent être liés à des régions géographiques comme les perméabilités ou porosités autour d'un puits ou plusieurs puits. L'écart entre les données d'historique et réponses simulées forme une fonctionnelle, dite fonction objectif. Le problème du calage d'historique se résout en minimisant cette fonctionnelle.

Plusieurs types de méthodes existent pour minimiser cette fonctionnelle. Certaines ne fournissent qu'un seul modèle correspondant au minimum de la fonction objectif. D'autres cherchent à estimer la loi de distribution des paramètres incertains conditionnée aux données dynamiques, dites loi a posteriori, et ainsi estimer l'incertitude sur les paramètres. En effet, l'incertitude sur les données mesurées et le simulateur d'écoulement se propage sur l'estimation du "meilleur" modèle de réservoir. Il est alors important de connaître la loi a posteriori autour du meilleur modèle. Dans le cas général, cette loi ne peut être connue qu'en générant un échantillon de valeurs suivant celle loi. On peut utiliser pour cela des méthodes de type Markov-Chain Monte Carlo (MCMC), qui convergent vers la loi voulue. Une telle méthode est décrite dans le document :

- Geyer C J (1992) Practical Markov chain Monte Carlo (with discussion). Statistical Science 7:473-511. doi:10.1214/ss/1177011137.

Les méthodes MCMC nécessitent un grand nombre de simulations d'écoulement, ce qui demande un temps de calcul important. Pour limiter l'utilisation du simulateur d'écoulement et donc pour réduire le temps de calcul, d'autres solutions ont été imaginées. Par exemple, il est possible d'utiliser un modèle de la fonction objectif dans l'espace des paramètres, appelé "surface de réponse". Ce modèle est construit progressivement au cours des itérations par interpolation des points simulés. Par exemple, le document suivant décrit une telle méthode :

- Busby D, Feraille M (2008) Adaptive Design of Experiments for Bayesian Inversion - An Application to Uncertainty Quantification of a Mature Oil Field. Journal of Physics: Conférence Series 135. doi: 10.1088/1742-6596/135/1/012026.

Cette approche présente donc deux niveaux d'approximation : le premier concerne la convergence de l'algorithme MCMC dont il est très difficile de dire s'il a convergé vers la loi voulue ; le second concerne l'approximation de la fonction objectif par la surface de réponse.

En outre, on connaît les documents:

- Feraille M et al. (2004) Uncertainty Quantification for Mature Field Combining the Bayesian inversion Formalism and Expérimental Design Approach. 9th European Conférence on the Mathematics of Oil Recovery - Cannes. 1 septembre 2004 (2004-09-01).
- Feraille M, Marrel A (2012) Prédiction under uncertainty on a mature field. Oil & Gas Science and Technology. doi: 10.2516/ogst/2011172.

Ces documents décrivent une méthode de calage d'historique d'un modèle de réservoir, dans laquelle on approxime la fonction objectif par un modèle approché.

Ainsi, l'objet de l'invention concerne un procédé d'exploitation d'un réservoir géologique selon un schéma d'exploitation défini à partir d'un modèle de réservoir. Le modèle de réservoir est obtenu par une technique de "calage d'historique" probabiliste prenant en compte une loi analytique de distribution conditionnelle de paramètres incertains associée à une surface de réponse donnée. Dans le procédé selon l'invention, cette surface de réponse n'approche pas la fonction objectif elle-même mais une autre fonction déterminée à partir de la fonction objectif. Ceci permet d'obtenir de meilleures approximations de la fonction objectif et donc de la loi a posteriori. De plus, l'utilisation d'une loi analytique permet de réduire les temps de calcul, d'envisager un traitement beaucoup plus rapide des résultats et d'obtenir un modèle de réservoir représentatif en limitant les approximations.

**Le procédé selon l'invention**

L'invention concerne un procédé d'exploitation d'un réservoir géologique selon la revendication 1.

Selon un mode de réalisation de l'invention, pour la première itération des étapes, ledit ensemble de modèles de réservoir est constitué lors de la construction de l'ensemble initial d'un nombre $M_0$ de modèles.

Selon l'invention, à l'étape iv) à chaque itération on génère plusieurs nouveaux modèles de réservoir, parmi lesquels on choisit $M_1$ modèles qu'on ajoute audit ensemble.

De manière avantageuse, lesdits $M_0$ modèles dudit ensemble initial sont échantillonnés par une technique de plan d'expériences de type hypercube latin.

De manière avantageuse, lesdits $M_1$ modèles ajoutés dans ledit ensemble sont choisis à l'aide de l'approximation de ladite fonction $G(\theta)$.

Selon une variante de réalisation de l'invention, au moins une partie desdits $M_1$ modèles sont les modèles pour lesquels l'approximation de la fonction $G(\theta)$ donne les valeurs maximales.

L'invention concerne également un produit programme d'ordinateur téléchargeable depuis un réseau de communication et/ou enregistré sur un support lisible par ordinateur et/ou exécutable par un processeur. Il comprend des instructions de code de programme pour la mise en œuvre du procédé tel que décrit ci-dessus, lorsque ledit programme est exécuté sur un ordinateur.

## Présentation succincte des figures

D'autres caractéristiques et avantages du procédé selon l'invention, apparaîtront à la lecture de la description ci-après d'exemples non limitatifs de réalisations, en se référant aux figures annexées et décrites ci-après.

La figure 1 illustre les différentes étapes du procédé selon l'invention.
La figure 2 illustre des valeurs de la fonction objectif pour les différents modèles de réservoir considérés au cours du processus de calage du procédé selon l'invention.
Les figures 3 illustrent la distribution de différents paramètres.
Les figures 4 illustrent la distribution de différents paramètres pour différentes périodes de calage.
Les figures 5 illustrent la distribution de différents paramètres lorsque certains paramètres sont fixés.
Les figures 6 illustrent des données de production au puits.
Les figures 7 à 12 illustrent la distribution de différents paramètres pour l'exemple 2.

## Description détaillée de l'invention

Le procédé de l'invention est destiné à l'exploitation d'un réservoir souterrain, cette exploitation peut consister à la récupération d'hydrocarbures mais aussi au stockage de gaz, tel que du $CO_2$ dans le réservoir. Dans la suite de la description, nous allons décrire essentiellement l'utilisation du procédé dans le cas de la récupération d'hydrocarbures.

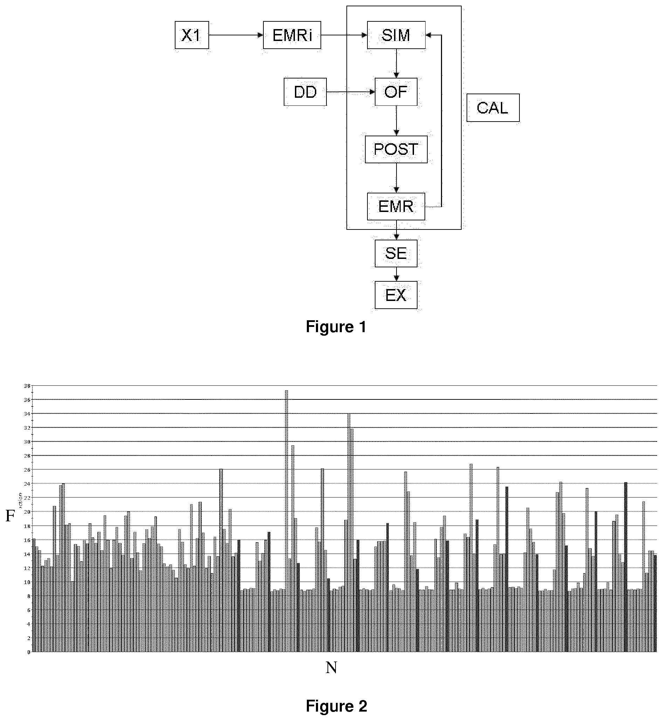

La figure 1 illustre le procédé d'exploitation d'un réservoir pétrolier selon l'invention. Le procédé comporte les étapes principales suivantes :

1) détermination de paramètres incertains (X1)

2) construction d'un ensemble initial de modèles de réservoir (EMRi)

3) calage d'historique de type probabiliste (CAL)

4) simulation de schémas d'exploitation (SE)

5) exploitation du gisement (EX)

Étape 1) détermination de paramètres incertains (X1)

Lors de cette étape, on détermine un ensemble de P paramètres incertains $\theta = (\theta_1 ... \theta_P)$ utilisés dans le modèle de réservoir ainsi que des lois de probabilité $p(\theta_i)$ (dites lois "a priori") pour chacun de ces paramètres. Ces lois n'incorporent aucune information venant des données dynamiques. Elles sont basées sur des informations venant de la connaissance du réservoir, de données statiques (géologiques par exemple), etc. Par exemple, les lois de probabilité $p(\theta)$ choisies peuvent être du type uniforme, Gaussien, etc.

Les paramètres incertains peuvent être liés à n'importe quelle partie du modèle de réservoir. Par exemple, il peut s'agir de paramètres permettant de remplir le modèle de réservoir en propriétés pétrophysiques (perméabilité, porosité), de paramètres caractérisant les puits (skins), les fluides en place ou injectés (saturation en huile résiduelle après balayage à l'eau ou au gaz par exemple) ou encore la structure du réservoir (connections de failles). Un jeu de valeurs des paramètres $\theta = (\theta_1 ... \theta_P)$, qui correspond également à un point de l'espace des paramètres, définit donc un modèle de réservoir. Une modification de chaque paramètre entraîne donc une modification du modèle de réservoir. En particulier, si le paramètre incertain est lié à la répartition spatiale d'une propriété pétrophysique, il peut être nécessaire d'utiliser une technique de simulation géostatistique pour générer le modèle de réservoir associé.

<u>Étape 2) construction d'un ensemble initial de modèles de réservoir (EMRi)</u>

Les formations géologiques sont en général des milieux très hétérogènes. La modélisation d'un réservoir, c'est-à-dire la construction d'un modèle de réservoir respectant les données statiques, nécessite de recourir à des procédés de construction dits « probabilistes » du fait de la limitation de l'information disponible (nombre de puits restreints, ...). De ce fait, les modèles géologiques construits à partir de ces procédés probabilistes sont appelés « modèles stochastiques ». La construction d'un modèle stochastique de réservoir doit d'abord dépendre de l'environnement du dépôt géologique, ce qui permet de représenter les hétérogénéités majeures qui contrôlent l'écoulement des fluides. L'intégration des données statiques dans ce modèle passe par des opérations linéaires et peut se faire à partir de techniques géostatistiques bien connues des spécialistes. Pour cela, on peut utiliser avantageusement un simulateur géostatistique.

Un modèle de réservoir, pouvant être représenté sur un ordinateur, comprend une grille à N dimensions (N>0 et en général égal à deux ou trois) dont chacune des mailles se voit affecter la valeur d'une propriété caractéristique de la zone étudiée. Il peut s'agir par exemple de la porosité ou de la perméabilité distribuée dans un réservoir. Ces valeurs constituent des cartes. Ainsi un modèle comprend une grille associée à au moins une carte. D'autres paramètres caractérisant par exemple les puits ou les fluides injectés interviennent également dans la définition de ce modèle.

Lors de cette étape on génère de manière stochastique un ensemble initial de modèles de réservoir au moyen de la loi de probabilité a priori $p(\theta)$ de chaque paramètre incertain.

Plus précisément, on génère pour chaque paramètre incertain $\theta_i$ sélectionné lors de l'étape 1), un échantillon (X1) de $M_0$ valeurs selon la loi de distribution a priori $p(\theta_i)$, par exemple à partir d'une méthode de plan d'expérience de type hypercube latin. On obtient ainsi un ensemble de $M_0$ jeux de valeurs des paramètres incertains, et donc $M_0$ modèles de réservoir différents.

<u>Étape 3) calage du modèle de réservoir (CAL)</u>

Le but du processus de calage selon l'invention est de construire un modèle de réservoir le plus représentatif possible. Or, à ce stade, les données dynamiques n'ont pas été considérées pour construire le modèle de réservoir initial. On acquiert donc des données dynamiques en cours d'exploitation du gisement (DD). Il s'agit de données de production, d'essais de puits, de temps de percée, de sismique 4D... dont la particularité est de varier au cours du temps en fonction des écoulements de fluide dans le réservoir. Ces mesures sont réalisées au moyen d'outils de mesure tels que des débitmètres ou des capteurs sismiques. On note $(y_1...y_n)$ le vecteur des données dynamiques observées et $(t_1...t_n)$ les temps d'acquisition correspondants.

Ces données dynamiques sont ensuite intégrées dans le modèle de réservoir par le biais du calage probabiliste. Selon l'invention, on réalise un calage d'historique de type probabiliste (CAL) en réalisant les étapes suivantes :

   i. on utilise un simulateur d'écoulement $f$ pour calculer la réponse en production simulée avec les modèles de réservoir que l'on souhaite évaluer (SIM) ;

   ii. on calcule une fonction objectif (OF) mesurant l'écart entre les résultats simulés (SIM) et les données dynamiques (DD) associées ;

   iii. on construit par krigeage une approximation de l'exponentielle de l'opposé de la fonction objectif, et on détermine pour cette surface de réponse une loi de probabilité conditionnelle analytique $\tilde{p}(\theta|y_1,..., y_n)$ des paramètres incertains connaissant les données dynamiques, cette loi est également appelée loi a posteriori (POST) ;

   iv. on génère au moins un nouveau modèle de réservoir que l'on souhaite évaluer pour améliorer la qualité de la surface de réponse (EMR) ;

   v. on réitère les étapes i) à iv), pour connaître le plus précisément possible la distribution a posteriori de la fonction objectif.

<u>i. simulation des données dynamiques (SIM)</u>

Au moyen d'un simulateur d'écoulement, par exemple le logiciel PumaFlow ® (IFP Energies nouvelles, France), on simule les écoulements dans les modèles de réservoir à évaluer, c'est à dire soit les modèles de réservoir de l'ensemble initial, soit les modèles de réservoir générés lors de l'itération précédente. On peut simuler par exemple la récupération de pétrole ou les déplacements des fluides (par exemple les gaz stockés) dans le réservoir.

ii. calcul d'une fonction objectif (OF)

La fonction objectif $F(\theta)$ représente les écarts entre les données dynamiques mesurées (DD) et les données dynamiques simulées (SIM). Selon un mode de réalisation de l'invention, on calcule la fonction objectif $F(\theta)$ au sens des moindres carrés :

$$F(\theta) = \frac{1}{2}\sum_{i=1}^{n}\omega_i\left(y_i - f\left(t_i,\theta\right)\right)^2$$

avec $\omega_i$ le poids associé à la donnée i.

Selon l'invention, on calcule la fonction objectif pour chaque modèle de réservoir de l'ensemble. On rappelle que cet ensemble comporte initialement $M = M_0$ modèles de réservoir. Cet ensemble augmente à chaque itération d'un nombre $M_1$ de modèles. La sélection des $M_1$ modèles supplémentaires, ou de façon équivalente des $M_1$ jeux de valeurs des paramètres incertains, est décrite dans le paragraphe iv) de sélection de nouveaux modèles de réservoir.

iii. détermination de la loi conditionnelle analytique (POST)

Le problème inverse en ingénierie de réservoir consiste à chercher la valeur de paramètres incertains du modèle réservoir qui, appliquées au simulateur d'écoulement, fournissent une réponse simulée la plus proche possible des données dynamiques mesurées. La réponse simulée aux puits se modélise de la façon suivante :

$$y_i = f\left(t_i,\theta\right) + \varepsilon_i \qquad i = 1,\ldots,n$$

où $t_i$ est le $i$-ième temps d'acquisition de données dynamiques, $y_i$ le vecteur des données dynamiques observées, $(\theta)$ le vecteur des paramètres incertains du modèle, $f$ le simulateur d'écoulement qui modélise la relation entre les paramètres et les données observées, $\varepsilon_i$ l'erreur entre le modèle et la donnée dynamique et n le nombre de données dynamiques mesurées. L'objectif est d'utiliser les données observées pour déduire des informations sur le vecteur des paramètres incertains $\theta$.

On suppose ici que les erreurs $\varepsilon_i$ entre le modèle de simulation d'écoulement $f(t_i, \theta)$ et les données observées $y_i$ suivent une loi donnée, estimée en fonction des erreurs de mesure. La loi de distribution conditionnelle du vecteur $\theta$ connaissant les données mesurées, ou loi a posteriori, est donnée par la formule de Bayes :

$$p\left(\theta\middle|y_1,\ldots,y_n\right) = \frac{p\left(y_1,\ldots,y_n\middle|\theta\right)\times p(\theta)}{p\left(y_1,\ldots,y_n\right)}$$

où $p(\theta)$ est la loi de distribution a priori, $p(y_1,\ldots,y_n)$ est la loi de distribution des données, $p(y_1,\ldots,y_n|\theta)$ est la loi de distribution conditionnelle des données dynamiques sachant $\theta$ et $p(\theta|y_1,\ldots,y_n)$ est la loi de distribution conditionnelle a posteriori recherchée. Enfin, en supposant les erreurs $\varepsilon_i$ Gaussiennes et indépendantes, la loi a posteriori peut se réécrire :

$$p\left(\theta\middle|y_1,\ldots,y_n\right) = \frac{\exp(-F(\theta))\times p(\theta)}{\int \exp(-F(\theta))\times p(\theta)d\theta}$$

Et dans ce cas, le poids $\omega_i$ utilisé pour le calcul de la fonction objectif est défini par $\omega_i = 1/\sigma_i^2$ avec $\sigma_i^2$ la variance de l'erreur $\varepsilon_i$.

Selon l'invention, on détermine une approximation de la loi $p(\theta|y_1,\ldots,y_n)$ de distribution conditionnelle des paramètres incertains connaissant les données dynamiques mesurées par une loi analytique $\tilde{p}(\theta|y_1,\ldots,y_n)$ dépendant de la fonction objectif $F(\theta)$.

On détermine ladite loi analytique conditionnelle $\tilde{p}(\theta|y_1,\ldots,y_n)$ en considérant une fonction $G(\theta)$ dépendante de ladite fonction objectif $F(\theta)$, définie par $G(\theta) = \exp(-F(\theta))$. La loi a posteriori se réécrit alors :

$$p\left(\theta|y_1,...,y_n\right) = \frac{G(\theta) \times p(\theta)}{\int G(\theta) \times p(\theta)d\theta}$$

. Cette relation découle de la relation que nous avons vu précédemment

$$p\left(\theta|y_1,...,y_n\right) = \frac{\exp(-F(\theta)) \times p(\theta)}{\int \exp(-F(\theta)) \times p(\theta)d\theta}$$

.

La fonction $G(\theta)$ n'étant pas connue de manière analytique, on en construit une approximation, appelée également surface de réponse, par interpolation des valeurs connues $G(\theta_j)$= exp(- $F(\theta_j)$) calculées pour chacun des modèles j de réservoir au cours de l'étape ii). Contrairement à l'art antérieur, la surface de réponse utilisée par l'invention approche non pas la fonction objectif, mais une fonction dépendant de cette fonction objectif. La fonction $G(\theta)$ est comprise entre 0 et 1, et varie donc dans un intervalle plus restreint que la fonction $F(\theta)$. Par conséquent, il est plus facile de construire une bonne approximation de la fonction $G(\theta)$ que de la fonction $F(\theta)$.

De préférence, la méthode d'interpolation utilisée est une technique de krigeage ou toute autre méthode de régression appartenant à la famille de la minimisation du risque empirique pénalisé dans des espaces de Hilbert à noyau reproduisant (RKHS de l'anglais Reproducting Kernel Hilbert Space). Ces méthodes d'interpolation permettent d'écrire l'approximation de la fonction (ou surface de réponse) $\tilde{G}(\theta)$ sous la forme d'une combinaison linéaire de fonctions connues. Le calcul de la loi $\tilde{p}(\theta|y_1,..., y_n)$ de probabilité conditionnelle associée à $\tilde{G}(\theta)$ fait alors intervenir différentes intégrales de ces fonctions connues, qui sont calculables analytiquement.

iv. sélection de nouveaux modèles de réservoir (EMR)

On génère de nouveaux modèles de réservoir, c'est à dire de nouveaux jeux de valeurs des paramètres incertains, en fonction de la loi analytique $\tilde{p}(\theta|y_1,..., y_n)$ de probabilité conditionnelle obtenue à l'étape précédente. On sélectionne $M_1$ modèles parmi cet échantillon pour lesquels on va calculer la fonction objectif afin d'améliorer notre connaissance de cette fonction, et donc la qualité de la surface de réponse.

Selon l'invention, l'ensemble des modèles de réservoir pour lesquels on calcule la réponse en production est augmenté à chaque itération du processus de calage par l'ajout de $M_1$ nouveaux modèles. Ces modèles sont choisis selon plusieurs critères (de préférence avec un nombre de modèles identique pour chacun des critères), notamment :

(i) on sélectionne les points de l'espace des paramètres, c'est à dire les jeux de valeur des paramètres incertains, pour lesquels la qualité de l'approximation de la fonction $G(\theta)$ est faible.

(ii) on sélectionne les points de l'espace des paramètres pour lesquels la surface de réponse $\tilde{G}(\theta)$ prédit de fortes valeurs, c'est-à-dire de faibles valeurs de la fonction objectif. On peut par exemple utiliser la technique de l'Expected Improvement (amélioration attendue) décrite par exemple dans le document : Schonlau M (1997) Computer Experiments and Global Optimization, Dissertation, University of Waterloo, Canada.

D'autres critères peuvent être utilisés notamment pour choisir des points où la variance de krigeage est élevée, les points qui si on les ajoute font diminuer le plus l'intégrale de l'erreur de modèle, ou les points d'entropie maximale, ....

On génère ensuite les modèles de réservoir correspondant à chaque nouveau jeu de valeurs des paramètres sélectionnés précédemment. Ceci peut nécessiter d'utiliser un simulateur géostatistique pour générer les propriétés pétrophysiques du modèle de réservoir.

v. répétition des étapes

Tant que le nombre maximum de points que l'on peut évaluer (simuler) n'a pas été atteint, on réitère les étapes du calage avec un nombre de modèles de réservoir appartenant à l'ensemble de plus en plus important.

A chaque construction par krigeage de $\tilde{G}(\theta)$, on calcule le critère de qualité Q2 de cette surface de réponse à

$$Q2 = 1 - \frac{\sum_{i=1}^{M}\left(G(\theta_i) - \tilde{G}_{-i}(\theta_i)\right)^2}{\sum_{i=1}^{M}\left(G(\theta_i) - \overline{G}\right)^2}$$

partir des modèles de réservoir de l'ensemble utilisé pour la définir: . Dans cette équation, on note $\overline{G}$ la moyenne des valeurs $G(\theta_i), i = 1...M$ et $\tilde{G}_{-i}(\theta_i)$ la prédiction pour les valeurs $\theta_i$ de la surface de réponse obtenue par krigeage en utilisant les M-1 jeux de valeurs $\theta_j$, $j = 1...M$, $j \neq i$. Selon un mode de réalisation de l'invention, il est possible de définir un critère Q2 en enlevant des groupes de mailles plutôt qu'une seule maille. D'autres types de critères de qualité peuvent être également utilisés. Le critère de qualité Q2 est meilleur si les fortes valeurs de G sont bien prédites. Dans notre cas, ces fortes valeurs correspondent à des valeurs de paramètres pour lesquelles la fonction objectif est faible, c'est-à-dire à des valeurs où l'adéquation avec les données d'historique est bonne. Ainsi, un critère Q2 élevé signifie que l'on approche correctement la fonction objectif pour des paramètres correspondant à un bon calage d'historique.

Dans le cas déterministe, un modèle de réservoir calé avec les données dynamiques revient à associer aux paramètres incertains (ou de calage du modèle) la valeur correspondant à la plus faible valeur de la fonction objectif. Dans notre cas, un modèle de réservoir calé avec les données dynamiques et selon la méthode probabiliste décrite précédemment revient à associer aux paramètres incertains (ou de calage du modèle) leur loi de probabilité a posteriori.

Selon un mode de réalisation de l'invention, on utilise une fonction objectif normalisée $F_s(\theta) = F(\theta)/s$ où $s$ est une constante de normalisation. Ceci implique de construire une approximation de $G_s(\theta) = \exp(-F(\theta)/s)$. Les étapes précédentes ii à iv sont conservées pour choisir de nouveaux modèles à simuler à l'aide de l'approximation de $G_s(\theta)$. Ensuite, on échantillonne la loi de probabilité a posteriori finale de la fonction objectif par une méthode MCMC, après évaluation d'un modèle de $F(\theta)$ par krigeage.

Étape 4) Simulation de schémas d'exploitation (SE)

A partir d'au moins un modèle de réservoir calé de manière probabiliste, les spécialistes peuvent déterminer plusieurs schémas d'exploitation (SE) correspondant à différentes options possibles d'exploitation du réservoir souterrain : emplacement des puits producteur et/ou injecteur, valeurs cibles pour les débits par puits et/ou pour le réservoir, le type d'outils utilisés, les fluides utilisés et récupérés... Pour chacun de ces schémas, il convient de déterminer leurs prévisions de production après la période de calage. Ces prévisions de production probabilistes sont obtenues au moyen d'un logiciel de simulateur d'écoulement (de préférence le même que celui utilisé auparavant) ainsi qu'au moyen du modèle numérique de réservoir calé.

On définit un ou plusieurs schémas d'exploitation (SE) possibles adaptés au modèle de réservoir. Pour chacun de ces schémas, on propage l'incertitude a posteriori obtenue après le calage probabiliste.

La propagation de la loi a posteriori des paramètres incertains peut être réalisée en construisant des surfaces de réponses sur les résultats d'intérêts de la simulation (débit cumulé d'huile ou valeur économique du réservoir, par exemple), ceci afin d'éviter le lancement d'un trop grand nombre de simulations numériques. La description de cette étape est donnée par exemple dans le document :

- Feraille M, Marrel A (2012) Prédiction under uncertainty on a mature field. Oil & Gas Science and Technology. doi: 10.2516/ogst/2011172.

A partir des prévisions de productions probabilistes définies pour chaque schéma d'exploitation (étape précédente), les spécialistes peuvent par comparaison choisir le schéma d'exploitation qui leur semble le plus pertinent. Par exemple :

- en comparant le maximum du volume d'huile récupéré, on peut déterminer le schéma de production susceptible de fournir le maximum de récupération ou d'être le plus rentable.

- en comparant l'écart type du volume d'huile récupéré, on peut déterminer le schéma de production le moins risqué.

Étape 5) Exploitation du réservoir souterrain (EX)

On exploite alors le réservoir selon le schéma d'exploitation choisi (EX) par exemple en forant de nouveaux puits (producteur ou injecteur), en modifiant les débits et/ou les fluides injectés ...

Exploitation des résultats

Le calcul analytique, donc quasi-instantané, des lois de probabilité a posteriori des paramètres et de la fonction objectif pour une surface de réponse donnée permet d'envisager de nouvelles voies d'exploitation des résultats du calage probabiliste permettant de mieux comprendre l'impact de chaque paramètre incertain sur le comportement du réservoir.

Par exemple, on peut décider de fixer la valeur d'un ou plusieurs des paramètres et de regarder l'impact sur l'incertitude des autres paramètres ainsi que sur la ou les fonctions objectif choisies. Dans ce cas, il suffit de recalculer analytiquement la loi de distribution conditionnelle des paramètres $\theta_j$, $j = 1...N$, $j \neq i$ conditionnée à la valeur choisie pour $\theta_i$.

On peut également envisager de considérer plusieurs fonctions objectif selon l'information recherchée. Ceci se fait en estimant la distribution a posteriori des paramètres pour chacune de ces fonctions via la construction d'une surface de réponse. La fonction objectif F mesure l'écart global entre les résultats de simulations et les données dynamiques mesurées. Cette fonction est classiquement construite au sens des moindres carrés. D'un point de vue métier, une fonction objectif calcule la somme des écarts entre des propriétés d'historique liées à des objets métiers (puits P1 à P10, groupe de puits, piège, ...), eux-mêmes liés à des propriétés comme le débit d'huile QOS, d'eau QWS, de gaz QGS, ..., qui sont elles-mêmes fonction du temps où ont été effectuées les mesures (par exemple tous les mois de 1980 à 2000). A partir des données d'historique, il est donc possible de calculer une fonction objectif pour n'importe quel sous-ensemble constitué d'une partie des objets, des propriétés ou d'un certain nombre d'intervalles de temps. Par exemple, on peut déterminer une fonction objectif liée :

- au puits P1 pour toutes les propriétés et tous les temps, ou

- à la période 1980-1990 pour tous les objets et toutes les propriétés.

Il peut donc être intéressant de connaître l'influence des paramètres sur différentes fonctions objectif, par exemple :

- pour identifier à partir de quel moment les différents paramètres deviennent influents, il suffit de considérer, pour plusieurs temps, la fonction objectif incluant toutes les données jusqu'à chacun de ces temps, puis de construire une surface de réponse pour chacune des fonctions obtenues. On a ainsi accès à l'évolution de la distribution a posteriori en fonction du temps de calage de manière interactive.

- pour connaître l'influence des paramètres sur chaque puits, il suffit d'estimer les distributions a posteriori des fonctions objectif associées aux propriétés d'un puits donné.

Connaître l'influence des paramètres incertains sur des fonctions objectif "métiers" définies par le spécialiste lui permet de mieux appréhender le fonctionnement du réservoir et de prendre des décisions. Par exemple, il est possible

- de fixer fictivement la valeur des paramètres vus comme influents, le spécialiste peut alors s'assurer que la réduction de l'incertitude sur le modèle de réservoir qui en découle (sur les autres paramètres et sur une ou plusieurs fonctions objectif définies par l'ingénieur) est suffisante pour justifier une meilleure caractérisation de ces paramètres influents. Dans ce cas, de nouvelles mesures sur le champ pétrolier peuvent être réalisées (tests de puits, diagraphies, ...).

- de savoir que des paramètres liés à une partie du réservoir commencent à avoir une influence à partir d'une date sur une ou des fonctions objectif liées à une autre partie du réservoir, ce qui permet de mieux comprendre le fonctionnement dynamique du réservoir. Cette compréhension peut se traduire par des schémas d'exploitation différents et adaptés pour chacune des parties du réservoir.

Enfin, on peut envisager des études de sensibilité aux poids de la fonction objectif, ce qui est extrêmement coûteux si l'on doit utiliser la méthode MCMC de l'art antérieur.

Exemples d'application

Afin d'illustrer le procédé selon l'invention, le demandeur a réalisé deux séries d'expérimentations. La première série concerne l'obtention des distributions a posteriori. La deuxième série illustre la bonne corrélation entre la loi analytique associée aux surfaces de réponse et la loi de distribution conditionnelle exacte.

Exemple 1

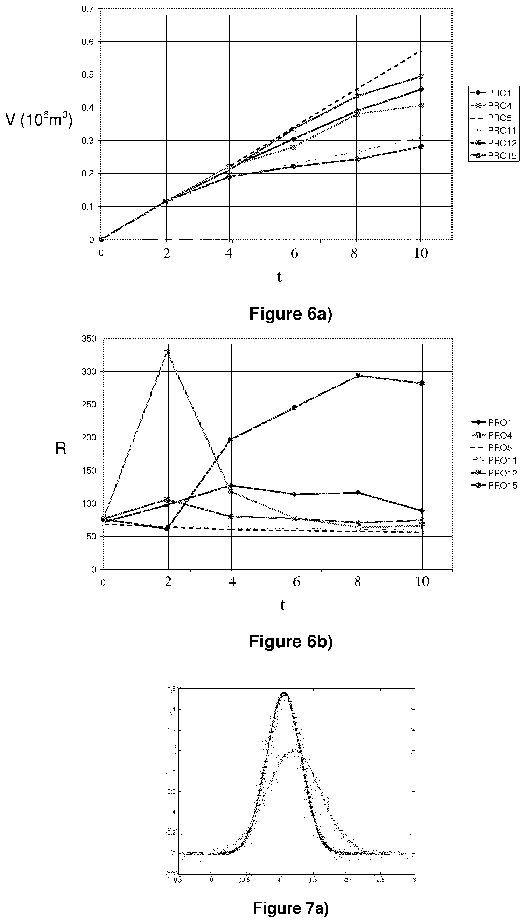

Pour illustrer la méthode, on décrit un exemple d'application synthétique. Le réservoir considéré contient initialement du gaz, de l'huile et de l'eau. Il est fermé par des failles sur deux côtés, et par un aquifère sur les autres côtés. La production se fait par déplétion à partir de six puits (PRO1, PRO4, PRO5, PRO11, PRO12, PRO15) avec un débit de production d'huile de 150 m$^3$/jour imposé à chaque puits producteur pendant 10 ans. Au cours de cette période de production, le cumulé d'huile (V) et le ratio gaz/huile (R) sont collectés pour chaque puits producteur, ainsi que le cumulé d'huile total dans le réservoir. Ces valeurs sont connues avec un bruit relatif de 4%. Ces données sont illustrées par les courbes de la figure 6. La figure 6a) correspond au volume (V) du cumulé d'huile pour chaque puits producteur en fonction du temps t exprimé en années. La figure 6b) correspond au ratio gaz/huile (R) pour chaque puits producteur en fonction du temps t exprimé en années.

On suppose également connue dans le réservoir la distribution des propriétés pétrophysiques (porosité, perméabilité). Les paramètres incertains sont les sept paramètres suivants : quatre multiplicateurs de transmissivité (MPH2, MPH1, MPV2, MPV1), la saturation en huile résiduelle après balayage à l'eau (SORW), la saturation en huile résiduelle après balayage au gaz (SORG) et un paramètre caractérisant l'aquifère (AQUI).

Il s'agit alors d'estimer, en utilisant le procédé selon l'invention, la distribution des paramètres incertains et la distribution de la fonction objectif conditionnées aux données dynamiques.

*Estimation des distributions a posteriori*

Le calage probabiliste est réalisé avec un plan d'expérience initial de type hypercube latin LHS définissant un ensemble constitué de 70 modèles de réservoir, puis avec un ajout de modèles par séries de 10 à chaque itération du processus de calage. Les 5 premiers modèles ajoutés sont choisis là où la surface de réponse $\tilde{G}(\theta)$ prédit de fortes valeurs, et les 5 suivants où la qualité de l'approximation de $G(\theta)$ est faible au sens de la variance de krigeage élevée. L'évolution de la fonction objectif au cours de la procédure d'ajout de modèles dans le processus de calage du modèle numérique du réservoir est donnée sur la Figure 2. Les barres verticales plus foncées marquent la dernière simulation du LHS et de chaque série d'ajout de modèles. On peut donc voir que, après les 70 premiers modèles d'exploration (LHS), les points ajoutés par séries de 10 présentent bien 5 premières valeurs globalement faibles de la fonction objectif, puis 5 valeurs globalement plus élevées.

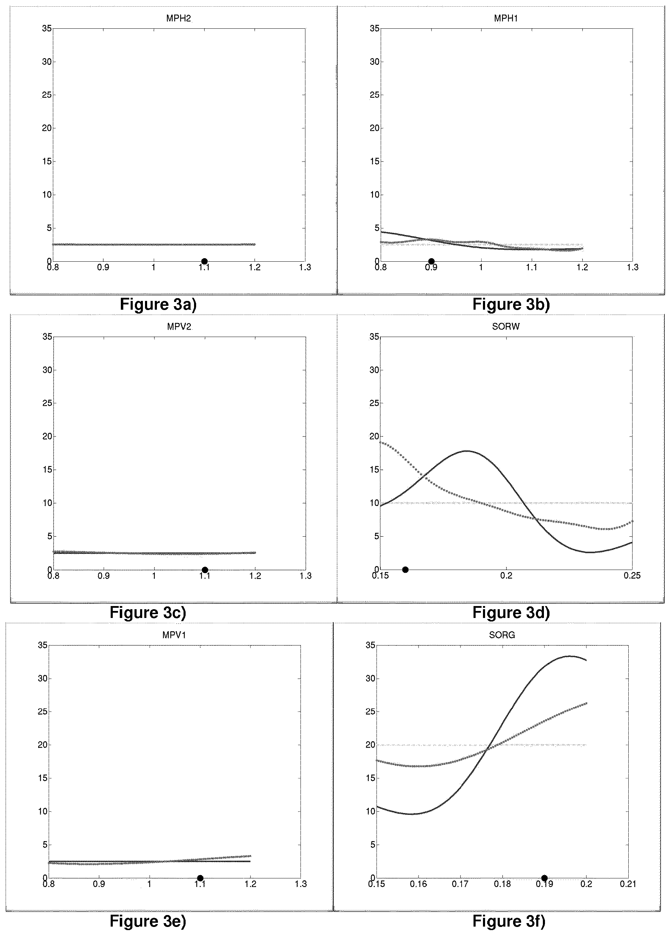

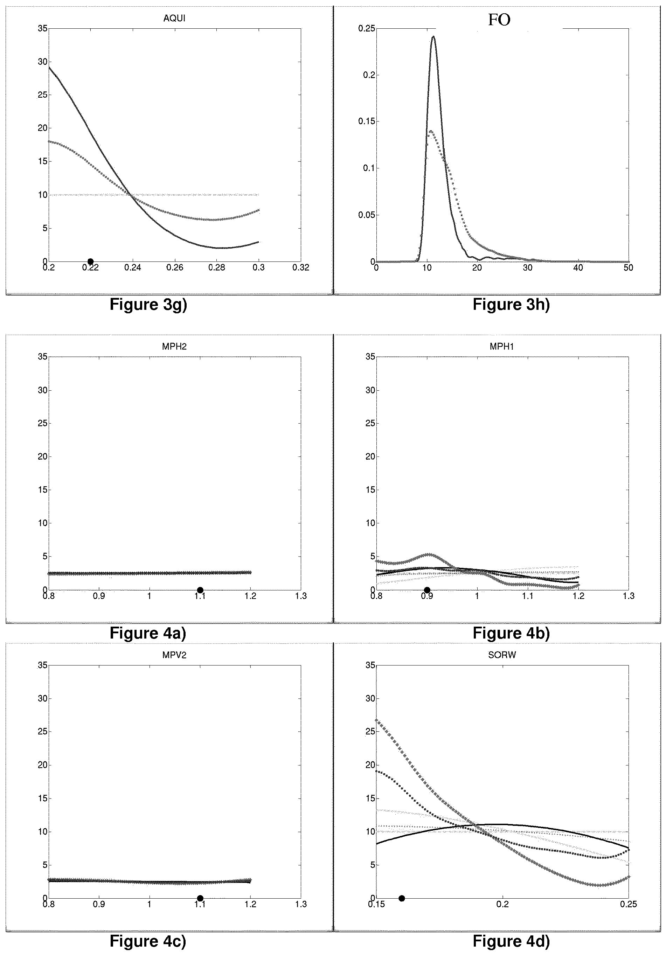

Les figures 3 représentent les courbes de la distribution a priori, de la distribution a posteriori déterminée après le plan d'expérience initial et de la distribution a posteriori à la fin du processus de calage pour chaque paramètre incertain (MPH2, MPH1, MPV2, MPV1, SORW, SORG, AQUI) et pour la fonction objectif (FO). Sur ces figures, le point noir indique la valeur de référence, la courbe discontinue en gris correspond à la loi de probabilité a priori, la courbe continue en noir correspond à la loi de probabilité a posteriori avec 70 modèles et la courbe discontinue en noir correspond à la loi de probabilité a posteriori à la fin du processus de calage avec 210 modèles.

*Exploitation des résultats*

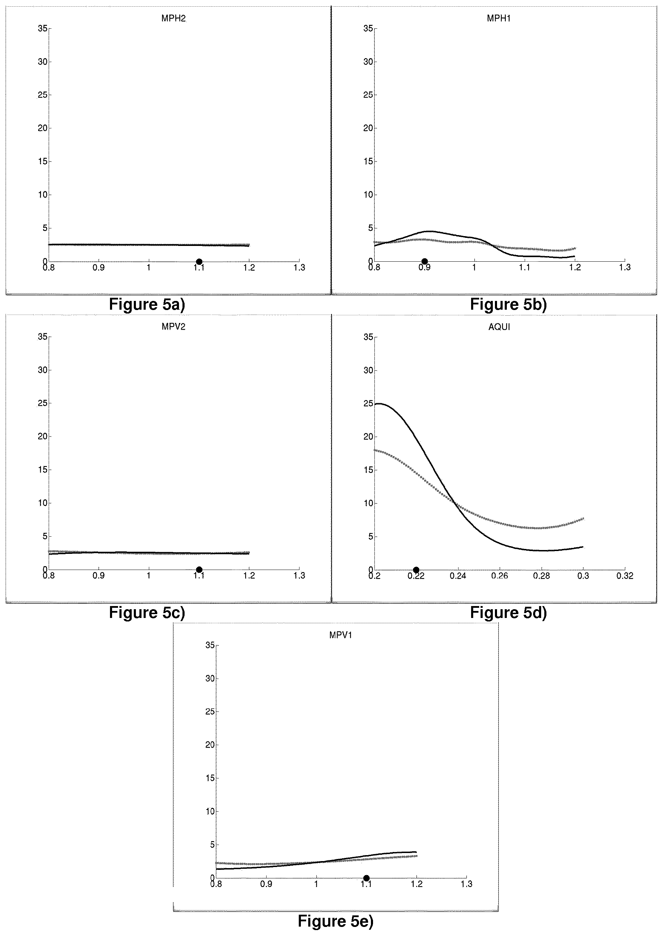

Grâce à la mise à jour quasi-immédiate (car analytique) de la distribution conditionnelle a posteriori pour un modèle de krigeage donné, on peut envisager de fixer la valeur d'un ou plusieurs des paramètres incertains et de regarder l'impact sur l'incertitude des autres paramètres. Ceci est illustré par exemple sur les figures 5 où sont représentées les distributions conditionnelles a posteriori à la fin du processus de calage des paramètres MPH2, MPH1, MPV2, MPV1 et AQUI en fixant ou non la valeur des paramètres SORG et SORW à leur valeur la plus probable. Sur ces figures, le point noir correspond à la valeur de référence, la courbe discontinue correspond à la loi de probabilité a posteriori lorsqu'aucun paramètre n'est fixé, alors que la courbe continue correspond à la loi de probabilité lorsqu'on fixe SORG et SORW. On voit ici que cela engendre une modification de certaines distributions.

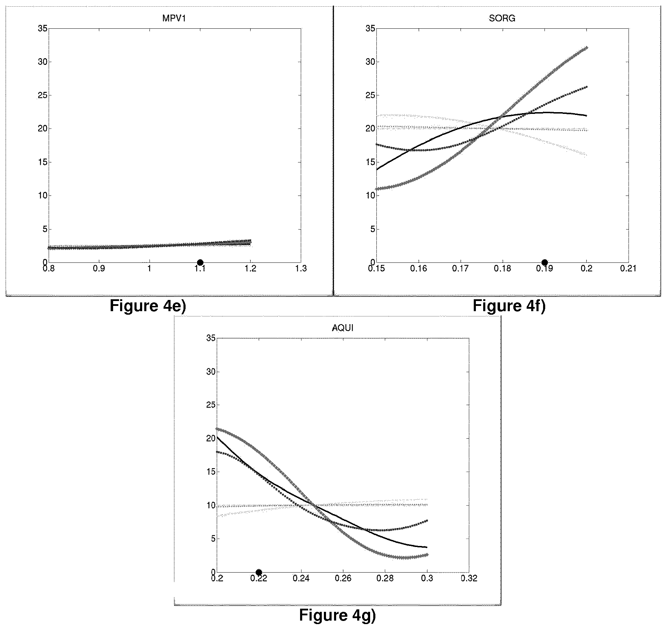

On peut également envisager des études de sensibilité aux poids de la fonction objectif. Par exemple, on peut s'intéresser à l'évolution des lois conditionnelles a posteriori des paramètres lorsque l'on considère un intervalle de calage plus ou moins long dans le calcul de la fonction objectif. Dans le cas présenté ici, on a considéré toutes les simulations effectuées lors du processus probabiliste et reconstruit le modèle de krigeage associé respectivement à un historique de 10, 8, 6, 4 et 2 ans. Les nouvelles lois conditionnelles a posteriori des paramètres sont données sur les figures 4. Sur ces figures, le point noir désigne la valeur de référence, la courbe discontinue en gris qui reste horizontale (uniforme) correspond à la loi de probabilité a priori, la courbe discontinue constituée d'une série de petits points correspond à la loi de probabilité a posteriori calculée pour deux ans, la courbe discontinue constituée d'une série de tirets correspond à la loi de probabilité a posteriori calculée pour quatre ans, la courbe continue correspond à la loi de probabilité a posteriori calculée pour six ans, la courbe discontinue constituée d'une série de losanges correspond à la loi de probabilité a posteriori calculée pour huit ans, et la courbe discontinue constituée d'une série de gros points correspond à la loi de probabilité a posteriori calculée pour dix ans. On remarque que les principaux changements interviennent après 6 ans.

Exemple 2

Cet exemple permet de détailler la méthodologie proposée sur un exemple analytique, qui nous permet de valider et d'étudier de manière approfondie les formes analytiques possibles de la loi a posteriori pour différents cas. Tous les exemples développés ici ont été traités avec le logiciel Matlab [®] (MathWorks, États-Unis) et la boîte à outils "Dacefit" pour la construction du krigeage.

Pour cet exemple on remplace le simulateur d'écoulement $f$ par un modèle linéaire $f(t_i, \theta) = t_i^T \theta$ où $\theta = (\theta_1 ... \theta_D)$ est un vecteur de dimension D.

Pour tester la méthode de calage du procédé selon l'invention sur ce modèle linéaire, on répète la procédure suivante pour D = 1, D = 2 et D = 3 :

1. On fixe la valeur de référence de θ

2. On choisit n = 10 points dans l'intervalle $[0,1]^D$ selon un hypercube latin, on note ces points $t_i$, i = 1,..,n et on génère les observations $y_i = t_i^T \theta + \varepsilon_i$ en générant aléatoirement des variables Gaussiennes $\varepsilon_i$ en se fixant une valeur $\sigma_\varepsilon^2$. D'une part, cette étape permet de générer les "fausses" données observées, ce qui permet de construire une fonction objectif. D'autre part elle permet de déduire (dans ce cas précis uniquement) les lois a posteriori exactes, pour les comparer aux lois approchées.

3. On génère un ensemble $(\theta_i)_{i=1,..,N}$ de N paramètres avec N = 10D, 20D, ou 50D selon un hypercube latin adapté à la loi a priori considérée et on calcule $(G_i)_{i=1,..,N}$ où $G(\theta_i) = \exp(-F(\theta_i))$ pour i = 1,.., N. Les choix N = 10D et N = 20D correspondent à des situations communes en pratique. Le choix N = 50D permet généralement d'avoir un modèle de krigeage extrêmement prédictif et sert ici de référence.

4. Pour chaque taille de l'échantillon des paramètres, on détermine la loi de distribution conditionnelle à partir des résultats de l'étape 3, que l'on compare aux lois a posteriori exactes.

• *Test pour θ à une dimension (D = 1)*

On choisit θ = 1.

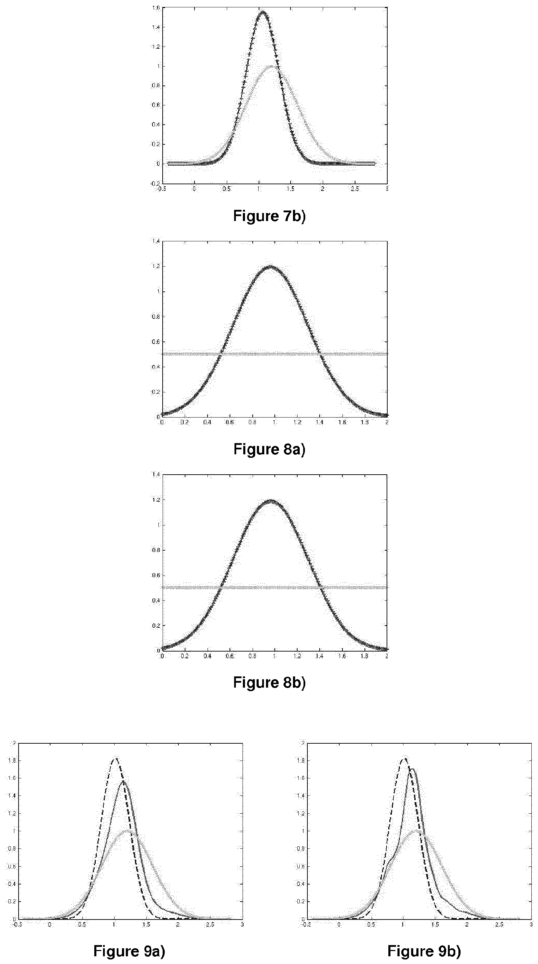

Dans le cas d'une loi a priori Gaussienne, on fixe la moyenne μ = 1.2 et un écart-type de 0.4. On représente en figure 7 la loi a priori (trait discontinu gris), la loi a posteriori approchée (constitué de croix) et la loi a posteriori exacte (constitué de tirets) pour N = 10D et pour une covariance Gaussienne (figure 7a)) et de Matern (figure 7b)). On remarque que dans les deux cas l'approximation est bonne : en effet, les lois de distribution a posteriori sont confondues. Par conséquent, ajouter des points supplémentaires (N=20D ou N=50D) n'est pas nécessaire.

Dans le cas d'une loi a priori uniforme, on fixe $[a_1, b_1]$ = [0,2]. On représente en figure 8 la loi a priori (trait continu gris), la loi a posteriori approchée (constitué de croix) et la loi a posteriori exacte (constitué de tirets) pour N = 10D et une covariance Gaussienne (figure 8a)) et de Matern (figure 8b)). Comme précédemment, l'approximation est de bonne qualité.

• *Test pour θ à deux dimensions (D = 2)*

On choisit θ = [1 1].

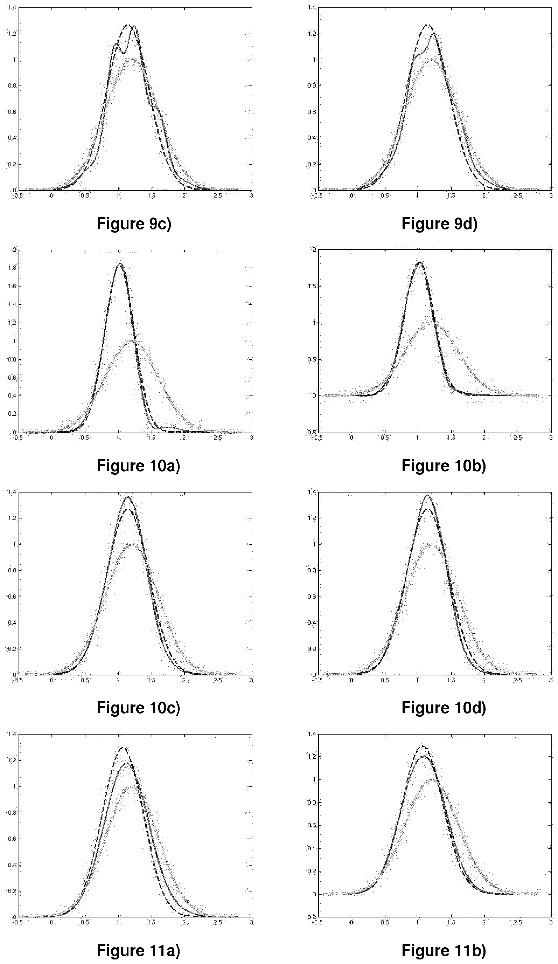

Dans le cas d'une loi a priori Gaussienne, on fixe la moyenne μ = [1,2 ; 1,2] et un écart-type de 0.4 pour chaque composante, toutes les deux étant indépendantes. On représente en figure 9 la loi a priori (trait continu en noir), la loi a posteriori approchée (constitué de croix) et la loi a posteriori exacte (constitué de tirets) pour N = 10D et pour une covariance Gaussienne (figures 9a) et 9c)) et de Matern (figure 9b) et 9d)). La première ligne (figures 9a) et 9b)) correspond à $\theta_1$ et la seconde (figures 9c) et d)) à $\theta_2$. On remarque que la loi approchée pour le premier paramètre est légèrement décentrée par rapport à la loi exacte. En revanche, la loi approchée pour le second paramètre est proche de la loi exacte.

Dans le cas d'une loi a priori uniforme, on fixe $[a_1, b_1]$ = $[a_2, b_2]$ = [0,2]. Dans ce cas, c'est la loi du premier paramètre qui est mieux approchée, alors que la loi du second présente des oscillations.

En terme de loi a posteriori, on obtient des approximations raisonnables pour seulement N = 10D.

Lorsque l'on augmente le nombre d'échantillons pour atteindre N = 20D, les approximations sont meilleures: le cas de la loi a priori Gaussienne est nettement amélioré (Figure 10a) à 10d)) et celui de la loi a priori uniforme légèrement. Les figures 10a) à 10d) correspondent aux figures 9a) à 9d) pour N = 20D.

Enfin, pour N = 50D, on obtient de très bonnes approximations. Les meilleurs résultats sont obtenus avec la loi a priori Gaussienne, le premier paramètre du cas uniforme présentant encore quelques oscillations.

• *Test pour $\theta$ à trois dimensions (D = 3)*

On choisit θ = [1 1 1].

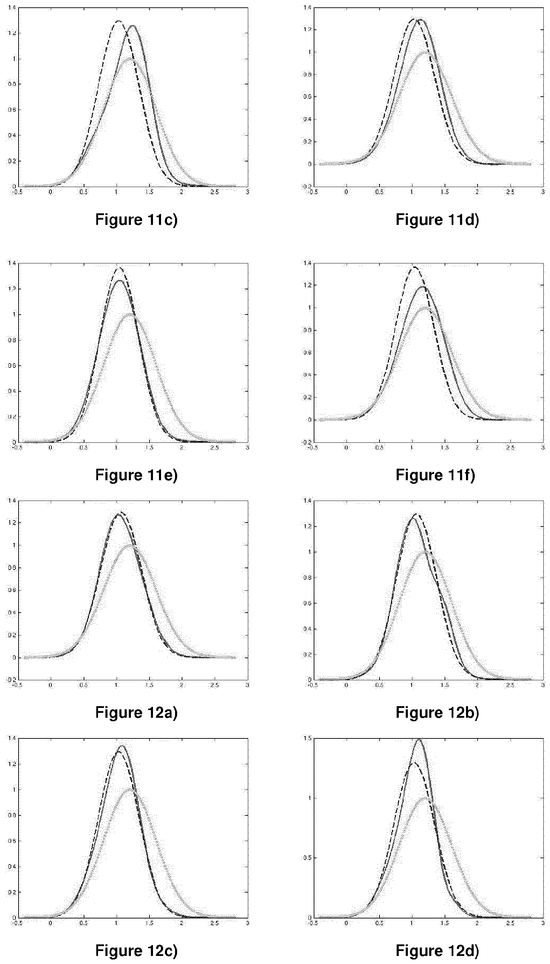

Dans le cas d'une loi a priori Gaussienne, on fixe la moyenne $\mu$ = [1,2 1,2 1,2] et un écart-type de 0,4 pour chaque composante, toutes les trois étant indépendantes. On représente en figure 11 la loi a priori (trait continu gris), la loi a posteriori approchée (trait continu en noir) et la loi a posteriori exacte (constitué de tirets) pour N = 10D et pour une covariance Gaussienne (figures 11a), c) et e)) et de Matern (figure 11b),d) et f)). La première ligne (figures 11a) et b)) correspond à $\theta_1$, la seconde (figures 11c) et d)) à $\theta_2$, la troisième (figures 11e) et f)) à $\theta_3$.

Dans le cas d'une loi a priori uniforme, on fixe [$a_1$, $b_1$] = [$a_2$, $b_2$] = [$a_3$, $b_3$] = [0,2]. Dans ce cas, les approximations sont moins précises.

Lorsque l'on augmente le nombre d'échantillons pour atteindre N = 20D, les approximations sont meilleures : le cas de la loi a priori Gaussienne est nettement amélioré et celui de la loi a priori uniforme légèrement.

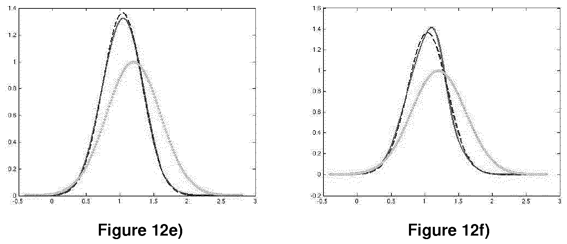

Enfin, pour N = 50D, on obtient de très bonnes approximations. Les figures 12a) à f) correspondent au figures 11a) à f) pour N = 50D.

Les différents tests montrent que lorsque la dimension D augmente, les résultats se dégradent. C'est un résultat attendu : plus l'espace des paramètres est grand, plus l'approximation par krigeage perd en précision. Cependant, les choix classiques du nombre de points dans l'espace des paramètres N = 10D et N = 20D fournissent malgré tout des approximations correctes. Pour cet exemple, les tests ne font pas appel à une procédure itérative pour rajouter des points. En pratique, lorsque l'on augmente la taille de l'ensemble, les points sont placés dans les régions d'intérêt et les approximations deviennent moins sensibles à la dimension.

On note que pour les simulations entreprises pour ces exemples, la loi analytique a posteriori obtenue grâce au procédé selon l'invention requiert un temps de calcul de l'ordre du centième de seconde, alors qu'un échantillonnage MCMC de l'art antérieur nécessite plusieurs minutes.

## Revendications

**1.** Procédé d'exploitation d'un réservoir géologique selon un schéma d'exploitation défini à partir d'un modèle de réservoir, ledit modèle de réservoir comportant un maillage associé à des paramètres $\theta$ dudit réservoir, **caractérisé en ce qu'**on réalise les étapes suivantes :

    a) on construit un modèle de réservoir calé sur des données mesurées au sein dudit réservoir au moyen des étapes suivantes :

        i) on génère de manière stochastique un ensemble initial de modèles de réservoir à partir de lois de probabilité $p(\theta)$ desdits paramètres $\theta$ ;

        ii) on détermine, pour chaque modèle de réservoir de l'ensemble, une fonction objectif $F(\theta)$ mesurant un écart entre n données dynamiques $y_1,..., y_n$ acquises en cours d'exploitation et des données dynamiques simulées au moyen d'un simulateur d'écoulement et desdits modèles de réservoir appartenant audit ensemble ;

        iii) on détermine à partir de ladite fonction objectif $F(\theta)$ déterminée pour chaque modèle de réservoir de l'ensemble, une loi analytique $\tilde{p}(\theta|y_1,...,y_n)$ de probabilité conditionnelle des paramètres $\theta$ connaissant lesdites données dynamiques mesurées $y_1,..., y_n$ en mettant en œuvre les étapes suivantes :

            (1) on détermine l'approximation d'une fonction $G(\theta)$ en calculant $G(\theta_j) = exp(-F(\theta_j))$ pour les modèles j appartenant audit ensemble, $\theta_j$ étant un paramètre incertain, puis par interpolation desdites valeurs de $G(\theta_j)$ ;

            (2) on calcule ladite loi analytique à partir de la relation suivante :

$$\tilde{p}\left(\theta\middle|y_1,...,y_n\right) = \frac{G(\theta) \times p(\theta)}{\int G(\theta) \times p(\theta)d\theta} \; ;$$

        iv) on génère au moins un nouveau modèle de réservoir au moyen de ladite loi analytique $\tilde{p}(\theta|y1,...,y_n)$ et on ajoute ledit nouveau modèle audit ensemble de modèles de réservoir ;

        v) on réitère les étapes ii) à iv) pour ledit ensemble de modèles de réservoir et on détermine le modèle de réservoir qui minimise ladite fonction objectif ;

b) on détermine un schéma d'exploitation optimal du réservoir en simulant l'exploitation du réservoir au moyen dudit modèle de réservoir calé et dudit simulateur d'écoulement ; et

c) on exploite ledit réservoir en mettant en œuvre ledit schéma d'exploitation optimal.

2. Procédé selon la revendication 1, dans lequel on interpole lesdites valeurs de $G(\theta_j)$ par une technique de krigeage.

3. Procédé selon l'une des revendications précédentes, pour la première itération des étapes, ledit ensemble de modèles de réservoir est constitué lors de la construction de l'ensemble initial d'un nombre $M_0$ de modèles.

4. Procédé selon la revendication 3, dans lequel à l'étape iv) à chaque itération, on génère plusieurs modèles de réservoir, parmi lesquels on choisit $M_1$ modèles qu'on ajoute audit ensemble.

5. Procédé selon la revendication 4, dans lequel lesdits $M_0$ modèles dudit ensemble initial sont échantillonnés par une technique de plan d'expériences de type hypercube latin.

6. Procédé selon l'une des revendications 4 et 5, dans lequel lesdits $M_1$ modèles ajoutés dans ledit ensemble sont choisis à l'aide de l'approximation de ladite fonction $G(\theta)$.

7. Procédé selon la revendication 6, dans lequel au moins une partie desdits $M_1$ modèles sont les modèles pour lesquels l'approximation de la fonction $G(\theta)$ donne les valeurs maximales.

8. Procédé selon l'une des revendications 6 ou 7, dans lequel au moins une partie desdits $M_1$ modèles sont les modèles pour lesquels la qualité de l'approximation de la fonction $G(\theta)$ possède des variances de krigeage les plus élevées parmi lesdits nouveaux modèles.

9. Procédé selon l'une des revendications précédentes, dans lequel on réalise une étude de sensibilité par le calcul de plusieurs fonctions objectif, chaque fonction objectif étant calculée pour une partie des paramètres ou pour un intervalle de temps limité par rapport aux informations disponibles.

10. Produit programme d'ordinateur téléchargeable depuis un réseau de communication et/ou enregistré sur un support lisible par ordinateur et/ou exécutable par un processeur, comprenant des instructions de code de programme pour la mise en œuvre du procédé selon l'une quelconque des revendications précédentes, lorsque ledit programme est exécuté sur un ordinateur.

**Patentansprüche**

1. Verfahren zur Ausbeutung eines geologischen Reservoirs gemäß einem Ausbeutungsplan, der auf Grundlage eines Reservoirmodells definiert wird, wobei das Reservoirmodell ein Maschenraster umfasst, das mit Parametern $\theta$ des Reservoirs assoziiert ist, **dadurch gekennzeichnet, dass** die folgenden Schritte durchgeführt werden:

a) Erstellen eines Reservoirmodells, das auf Daten, die innerhalb des Reservoirs gemessen werden, abgestimmt ist, mittels der folgenden Schritte:

i) Erzeugen, auf stochastische Weise, eines anfänglichen Satzes von Reservoirmodellen auf Grundlage von Wahrscheinlichkeitsgesetzen $p(0)$ der Parameter $\theta$;
ii) Bestimmen, für jedes Reservoirmodell des Satzes, einer Zielfunktion $F(\theta)$, die eine Differenz zwischen n dynamischen Daten $y_1,...,y_n$, die im Laufe der Ausbeutung erlangt wurden, und dynamischen Daten, die mittels eines Strömungssimulators und der Reservoirmodelle, die zu dem Satz gehören, simuliert werden, misst;
iii) Bestimmen, auf Grundlage der Zielfunktion $F(\theta)$, die für jedes Reservoirmodell des Satzes bestimmt wurde, eines analytischen Gesetzes $\tilde{p}(\theta|y_1,...,y_n)$ der bedingten Wahrscheinlichkeit für die Parameter $\theta$, dem die gemessenen dynamischen Daten $y_1,...,y_n$ bekannt sind, durch Umsetzung der folgenden Schritte:

(1) Bestimmen der Approximation einer Funktion $G(\theta)$ durch das Berechnen von $G(\theta_j) = exp\ (-F(\theta j))$ für die Modelle j, die zu dem Satz gehören, wobei $\theta_j$ ein unsicherer Parameter ist, und dann durch Interpolation der Werte von $G(\theta_j)$;
(2) Berechnen des analytischen Gesetzes auf Grundlage der folgenden Gleichung:

$$\tilde{p}(\theta|y_1,\ldots,y_n) = \frac{G(\theta) \times p(\theta)}{\int G(\theta) \times p(\theta)d\theta};$$

iv) Erzeugen mindestens eines neuen Reservoirmodells mittels des analytischen Gesetzes $\tilde{p}(\theta|y_1,\ldots,y_n)$ und Hinzufügen des neuen Modells zu dem Satz von Reservoirmodellen;

v) Wiederholen der Schritte ii) bis iv) für den Satz von Reservoirmodellen und Bestimmen des Reservoirmodells, das die Zielfunktion minimiert;

b) Bestimmen eines optimalen Ausbeutungsplans für das Reservoir, indem die Ausbeutung des Reservoirs mittels des abgestimmten Reservoirmodells und des Strömungssimulators simuliert wird; und

c) Ausbeuten des Reservoirs, indem der optimale Ausbeutungsplan umgesetzt wird.

2. Verfahren nach Anspruch 1, wobei die Werte von $G(\theta_j)$ durch eine Kriging-Technik interpoliert werden.

3. Verfahren nach einem der vorhergehenden Ansprüche, wobei bei der ersten Wiederholung der Schritte der Satz von Reservoirmodellen bei der Erstellung des anfänglichen Satzes aus einer Anzahl $M_0$ von Modellen gebildet wird.

4. Verfahren nach Anspruch 3, wobei in dem Schritt iv) bei jeder Wiederholung mehrere Reservoirmodelle erzeugt werden, aus denen $M_1$ Modelle gewählt werden, die zu dem Satz hinzugefügt werden.

5. Verfahren nach Anspruch 4, wobei die $M_0$ Modelle des anfänglichen Satzes anhand einer statistischen Versuchsplanung vom Typ Latin Hypercube ausgewählt werden.

6. Verfahren nach einem der Ansprüche 4 und 5, wobei die dem Satz hinzugefügten $M_1$ Modelle mit Hilfe der Appro-ximation der Funktion $G(\theta)$ gewählt werden.

7. Verfahren nach Anspruch 6, wobei mindestens ein Teil der $M_1$ Modelle Modelle sind, bei denen die Approximation der Funktion $G(\theta)$ die maximalen Werte ergibt.

8. Verfahren nach einem der Ansprüche 6 oder 7, wobei mindestens ein Teil der $M_1$ Modelle Modelle sind, bei denen die Qualität der Approximation der Funktion $G(\theta)$ Kriging-Varianzen besitzt, die innerhalb der neuen Modelle am höchsten sind.

9. Verfahren nach einem der vorhergehenden Ansprüche, wobei durch die Berechnung mehrerer Zielfunktionen eine Sensibilitätsanalyse durchgeführt wird, wobei jede Zielfunktion mit Bezug auf die verfügbaren Informationen für einen Teil der Parameter oder für ein begrenztes Zeitintervall berechnet wird.

10. Computerprogrammprodukt, das aus einem Kommunikationsnetzwerk heruntergeladen werden kann und/oder auf einem computerlesbaren Medium aufgezeichnet ist und/oder von einem Prozessor ausgeführt werden kann, das Programmcodeanweisungen zur Umsetzung des Verfahrens nach einem der vorhergehenden Ansprüche beinhaltet, wenn das Programm auf einem Computer ausgeführt wird.

**Claims**

1. Method for exploiting a geological reservoir according to an exploitation scheme defined on the basis of a reservoir model, said reservoir model comprising a mesh associated with parameters $\theta$ of said reservoir, **characterised in that** the following steps are carried out:

a) a reservoir model matched to data measured within said reservoir is constructed by means of the following steps:

i) stochastically, an initial set of reservoir models is generated on the basis of probability distributions $p(\theta)$ of said parameters $\theta$;

ii) for each reservoir model of the set, an objective function $F(\theta)$ measuring a deviation between n dynamic data $y_1,\ldots,y_n$ acquired during exploitation and dynamic data simulated by means of a flow simulator and of said reservoir models belonging to said set, is determined;

iii) on the basis of said objective function $F(\theta)$ determined for each reservoir model of the set, an analytical conditional-probability distribution $\tilde{p}(\theta|y_i,...,y_n)$ of the parameters $\theta$ is determined, knowing said measured dynamic data $y_i,...,y_n$, by implementing the following steps:

(1) the approximation of a function $G(\theta)$ is determined by computing $G(\theta_j) = exp(-F(\theta_j))$ for the j models belonging to said set, $\theta_j$ being an uncertain parameter, then by interpolating said values of $G(\theta_j)$;
(2) said analytical distribution is computed on the basis of the following relationship:

$$\tilde{p}(\theta|y_1,\ldots,y_n) = \frac{G(\theta) \times p(\theta)}{\int G(\theta) \times p(\theta)d\theta} ;$$

iv) at least one new reservoir model is generated by means of said analytical distribution $\tilde{p}(\theta|y_1,..., y_n)$ and said new model is added to said set of reservoir models;
v) steps ii) to iv) are reiterated for said set of reservoir models and the reservoir model that minimizes said objective function is determined;

b) an optimal exploitation scheme is determined for the reservoir by simulating the exploitation of the reservoir by means of said matched reservoir model and of said flow simulator; and
c) said reservoir is exploited by implementing said optimal exploitation scheme.

2. Method according to Claim 1, wherein said values of $G(\theta_j)$ are interpolated using a kriging technique.

3. Method according to one of the preceding claims, wherein, in the first iteration of the steps, said set of reservoir models is formed during the construction of the initial set of a number $M_0$ of models.

4. Method according to Claim 3, wherein, in step iv), in each iteration, a plurality of reservoir models are generated, from which $M_1$ models are chosen added to said set.

5. Method according to Claim 4, wherein said $M_1$ models of said initial set are sampled using a design-of-experiments technique of Latin hypercube type.

6. Method according to one of Claims 4 and 5, wherein said $M_1$ models added to said set are chosen using the approximation of said function $G(\theta)$.

7. Method according to Claim 6, wherein at least some of said $M_1$ models are models for which the approximation of the function $G(\theta)$ gives maximum values.

8. Method according to one of Claims 6 and 7, wherein at least some of said $M_1$ models are the models for which the quality of the approximation of the function $G(\theta)$ possesses the highest kriging variances among said new models.

9. Method according to one of the preceding claims, wherein a sensitivity study is carried out by computing a plurality of objective functions, each objective function being computed for some of the parameters or for a time interval that is limited with respect to the available information.

10. Computer program product that is downloadable from a communication network and/or stored on a medium that is computer-readable and/or that is executable by a processor, comprising program code instructions for implementing the method according to any one of the preceding claims, when said program is executed on a computer.

Figure 1

Figure 2

Figure 3a)

Figure 3b)

Figure 3c)

Figure 3d)

Figure 3e)

Figure 3f)

**Figure 3g)**

**Figure 3h)**

**Figure 4a)**

**Figure 4b)**

**Figure 4c)**

**Figure 4d)**

Figure 4e)

Figure 4f)

Figure 4g)

Figure 5a)

Figure 5b)

Figure 5c)

Figure 5d)

Figure 5e)

Figure 6a)

Figure 6b)

Figure 7a)

**Figure 7b)**

**Figure 8a)**

**Figure 8b)**

**Figure 9a)**          **Figure 9b)**

Figure 9c)

Figure 9d)

Figure 10a)

Figure 10b)

Figure 10c)

Figure 10d)

Figure 11a)

Figure 11b)

Figure 11c)

Figure 11d)

Figure 11e)

Figure 11f)

Figure 12a)

Figure 12b)

Figure 12c)

Figure 12d)

Figure 12e)

Figure 12f)

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **GOOVAERTS,P.** Geostatistics for natural resources évaluation. Oxford Press, 1997, 483
- **LE RAVALEC, M. ; NœTINGER B. ; HU L.-Y.** The FFT moving average (FFT-MA) generator: an efficient numerical method for generating and conditioning Gaussian simulations. *Mathematical Geology,* 2000, vol. 32 (6), 701-723
- **GEYER C J.** Practical Markov chain Monte Carlo (with discussion). *Statistical Science,* 1992, vol. 7, 473-511
- **BUSBY D ; FERAILLE M.** Adaptive Design of Experiments for Bayesian Inversion - An Application to Uncertainty Quantification of a Mature Oil Field. *Journal of Physics: Conférence Series,* 2008, 135
- **FERAILLE M et al.** Uncertainty Quantification for Mature Field Combining the Bayesian inversion Formalism and Expérimental Design Approach. *9th European Conférence on the Mathematics of Oil Recovery - Cannes,* 01 Septembre 2004
- **FERAILLE M ; MARREL A.** Prédiction under uncertainty on a mature field. *Oil & Gas Science and Technology,* 2012
- Computer Experiments and Global Optimization. **SCHONLAU M.** Dissertation. University of Waterloo, 1997